# EUROPEAN PATENT APPLICATION

(11) **EP 3 528 280 A1**
(43) Date of publication of application: **21.08.2019**
(21) Application number: 17889524.9
(22) Date of filing: 25.12.2017
(51) Int. Cl.: H01L 21/677

(54) **SOLAR CELL CO-EVAPORATION PRODUCTION LINE**

(30) Priority: 19.12.2017 CN 201711376921
(71) Applicant: Beijing Apollo Ding Rong Solar Technology Co., Ltd., Beijing 100176 (CN)
(72) Inventor: LIN, Jian, Beijing 100176 (CN); QI, Weibin, Beijing 100176 (CN); ZHU, Kai, Beijing 100176 (CN)
(74) Representative: Cabinet Beau de Loménie
(86) International application number: PCT/CN2017/118219
(87) International publication number: WO 2019/119463

(57) **Abstract**

The present disclosure discloses a solar cell co-evaporation production line, which includes a base support transfer line, a substrate transfer line, and a master control room. The base support transfer line is provided with a base support upper line port and a base support lower line port. The substrate transfer line is connected to a co-evaporation device and is provided with a feed port and a discharge port. Both the feed port and the discharge port are connected to the base support transfer line. The master control room is used for controlling the base support transfer line and the substrate transfer line to act. The solar cell co-evaporation production line provided by the present disclosure implements automatic transferring and processing of a copper-indium-gallium-selenium (CIGS) thin-film cell in a co-evaporation process by arranging the base support transfer line and the substrate transfer line, also implements an automatic circulation of the base support, saves manpower, increases production efficiency, and saves production costs.

## Description

### TECHNICAL FIELD

The present disclosure relates to the field of solar cell manufacturing technologies, and more particularly, to a solar cell co-evaporation production line.

### BACKGROUND

Preparation technologies for manufacturing copper-indium-gallium-selenium (CIGS) thin-films include: substrate cleaning, magnetron sputtering a molybdenum layer, laser scribing, CIGS co-evaporation, chemical bath deposition, mechanical scribing, and magnetron sputtering a transparent conductive oxide (TCO) layer. The CIGS co-evaporation and chemical bath deposition technologies generally are implemented via co-evaporation devices and chemical bath devices respectively. Whereas in the prior art, silicon-based thin-film solar cell production lines are not equipped with the co-evaporation devices, the chemical bath devices or transfer lines for transferring substrates to the co-evaporation devices and the chemical bath devices. Therefore, the silicon-based thin-film solar cell production lines can't satisfy requirements for production of CIGS thin-film solar cells. That is, two different production lines are required to produce the silicon-based thin-film solar cells and the CIGS thin-film solar cells, which greatly increases production costs.

Furthermore, the co-evaporation process requires a film-coated surface of the TCO layer to face toward the ground, but in the process prior to the co-evaporation, the film-coated surface of the TCO layer faces toward a direction diverging from the ground. Whereas the silicon-based thin-film solar cell production lines are not equipped with structures for reversing the substrates, such that reversing the substrates generally is completed by manual operation, which reduces the production efficiency and increases labor costs.

### SUMMARY

An objective of the present disclosure is to provide a solar cell co-evaporation production line to solve the problems in the prior art, to produce silicon-based thin-film cells and copper-indium-gallium-selenium (CIGS) thin-film cells in the same transfer line, to increase production efficiency, and to reduce production costs.

The present disclosure provides a solar cell co-evaporation production line, which includes:
a base support transfer line, provided with a base support upper line port and a base support lower line port;
a substrate transfer line, connected to a co-evaporation device and provided with a feed port and a discharge port, both the feed port and the discharge port being connected to the base support transfer line; and
a master control room, used for controlling the base support transfer line and the substrate transfer line to act.

Preferably, the solar cell co-evaporation production line as mentioned above further includes a substrate upper line apparatus and a substrate lower line apparatus connected to the base support transfer line. The substrate upper line apparatus is used for conveying a substrate onto the base support, and the substrate lower line apparatus is used for taking away the substrate from the base support.

Preferably, the solar cell co-evaporation production line as mentioned above further includes a base support upper line apparatus and a base support lower line apparatus. The base support upper line apparatus is connected to the base support upper line port and is used for conveying the base support onto the base support transfer line. The base support lower line apparatus is connected to the base support lower line port and is used for taking away the base support from the base support transfer line.

In the solar cell co-evaporation production line as mentioned above, preferably, the base support upper line apparatus is connected to the base support lower line apparatus.

In the solar cell co-evaporation production line as mentioned above, preferably, both the substrate upper line apparatus and the substrate lower line apparatus are provided with a driving mechanism, a reversing mechanism, and a clamping mechanism. An output end of the driving mechanism is connected to one end of the reversing mechanism to drive the reversing mechanism to rotate, and the reversing mechanism is connected to the clamping mechanism.

In the solar cell co-evaporation production line as mentioned above, preferably, the clamping mechanism is a vacuum chuck, the reversing mechanism is provided with a vacuum pump, and the vacuum pump is connected to the vacuum chuck.

Preferably, the solar cell co-evaporation production line as mentioned above further includes a position detecting apparatus. The position detecting apparatus is respectively arranged on the substrate upper line apparatus and the substrate lower line apparatus.

In the solar cell co-evaporation production line as mentioned above, preferably, the base support includes a longitudinal beam and a cross beam perpendicular to each other. At least two co-evaporation areas for placing the substrate are formed between the longitudinal beam and the cross beam.

In the solar cell co-evaporation production line as mentioned above, preferably, the substrate transfer line includes a substrate feed line and a substrate blanking line. The substrate feed line is connected to an input end of the co-evaporation device, and the substrate blanking line is connected to an output end of the co-evaporation device. The feed port is arranged on the substrate feed line, and the discharge port is arranged on the substrate blanking line.

In the solar cell co-evaporation production line as mentioned above, preferably, the substrate feed line is provided with a plurality of input lines, and each of the input lines is connected to an input end of the co-evaporation device. The substrate blanking line is provided with a plurality of output lines, and each of the output lines is connected to an output end of the co-evaporation device.

The solar cell co-evaporation production line provided by the present disclosure implements automatic transferring and processing of a copper-indium-gallium-selenium (CIGS) thin-film cell in a co-evaporation process by arranging the base support transfer line and the substrate transfer line, also implements an automatic circulation of the base support, saves manpower, increases production efficiency, and saves production costs.

### BRIEF DESCRIPTION OF THE DRAWING

FIG. 1 is a schematic structural diagram of a solar cell co-evaporation production line according to an embodiment of the present disclosure;
FIG. 2 is a schematic structural diagram of a reversing mechanism;
FIG. 3 is a schematic structural diagram of a base support; and
FIG. 4 is a state diagram showing that a substrate is placed on the base support.

Reference numbers in the attached drawings:
100-base support transfer line; 200-substrate transfer line; 210-substrate feed line;
211-feed port; 212-input line; 220-substrate blanking line;
221-discharge port; 222-output line; 300-co-evaporation device;
400-substrate; 500-base support; 510-longitudinal beam;
520-cross beam; 530-co-evaporation area; 600-substrate upper line apparatus;
700-substrate lower line apparatus; 800-base support upper line apparatus; 900-base support lower line apparatus;
10-rotating arm; 20-rotating shaft; 30-clamping mechanism.

### DETAILED DESCRIPTION OF THE EMBODIMENTS

The embodiments of the disclosure will be described in detail as below. Examples of the embodiments are as shown in drawings, in which same or similar reference numbers always represent same or similar elements or elements with same or similar functions. The embodiments described with reference to the drawings are exemplary, just used for explaining the disclosure, not for limiting the disclosure.

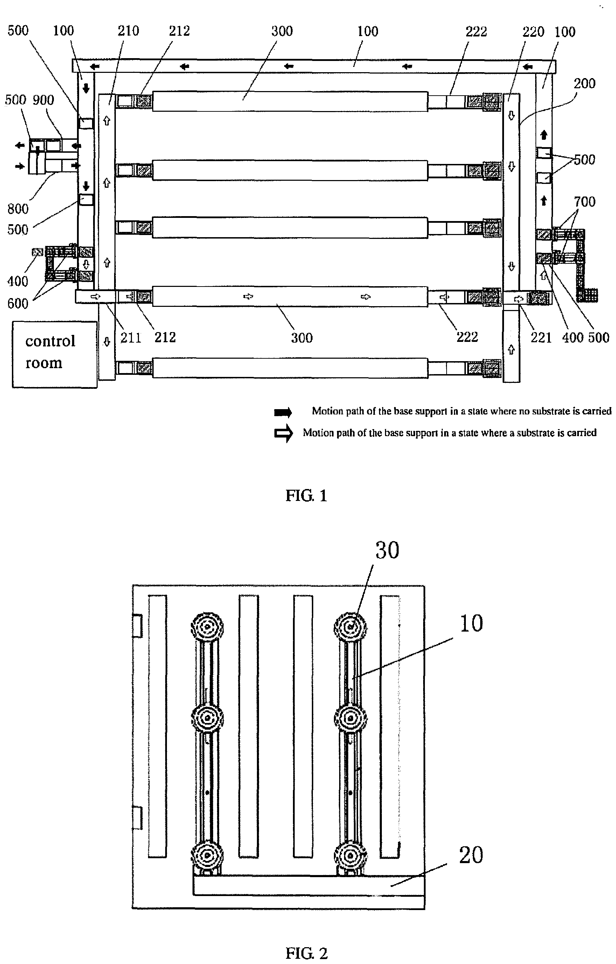

As shown in FIG. 1, an embodiment of the present disclosure provides a solar cell co-evaporation production line, which includes a base support transfer line 100, a substrate transfer line 200, and a master control room. The base support transfer line 100 is provided with a base support upper line port and a base support lower line port. The substrate transfer line 200 is connected to a co-evaporation device 300 and is provided with a feed port 211 and a discharge port 221. Both the feed port 211 and the discharge port 221 are connected to the base support transfer line 100. The master control room is used for controlling the base support transfer line 100 and the substrate transfer line 200 to act.

It is to be understood that the solar cell co-evaporation production line may be respectively connected to a previous process production line and a next process production line, such that after the previous process is completed for a substrate 400, the substrate 400 may be automatically conveyed, via a conveying device, to the solar cell co-evaporation production line provided by the embodiment of the present disclosure to carry out co-evaporation. After the co-evaporation is completed, the substrate 400 may be automatically conveyed, via the conveying device, to the next process production line to carry out subsequent processing.

When it is required to perform co-evaporation on the substrate 400 for which the previous process has been completed, a base support 500 may be placed, from a base support upper line port, onto the base support transfer line 100. When the base support 500 is conveyed to the feed port 211 of the substrate transfer line 200, the substrate 400 may be conveyed, via the conveying device, to the base support 500 and is circulated with the base support transfer line 100. When the base support 500 on which the substrate 400 is carried is conveyed to the feed port 211 of the substrate transfer line 200, the base support 500 on which the substrate 400 is carried may be conveyed to the substrate transfer line 200 and is conveyed by the substrate transfer line 200 to the co-evaporation device 300 to perform co-evaporation on the substrate 400. After the co-evaporation of the substrate 400 is completed, the base support 500 on which the substrate 400 is carried may be conveyed from the discharge port 221 to the base support transfer line 100 via the substrate transfer line 200, and the substrate 400 on the base support 500 may be outputted to the next process production line via the conveying device to carry out the subsequent processing. The base support 500 from which the substrate 400 is removed may be further transferred by the base support transfer line 100 to the base support lower line port to recycle the base support 500. Thus, the solar cell co-evaporation production line additionally provided for the existing silicon-based thin-film solar cell production line according to the embodiment of the present disclosure implements production and processing of a copper-indium-gallium-selenium (CIGS) thin-film cell, effectively saves production costs, and also implements an automatic circulation of the substrate 400, and saves manpower.

Specifically, as shown in FIG. 1, the substrate transfer line 200 may include a substrate feed line 210 and a substrate blanking line 220. The substrate feed line 210 is connected to an input end of the co-evaporation device 300, and the substrate blanking line 220 is connected to an output end of the co-evaporation device 300. The feed port 211 is arranged on the substrate feed line 210, and the discharge port 221 is arranged on the substrate blanking line 220. The base support 500 on which the substrate 400 is carried may be conveyed to the co-evaporation device 300 via the substrate feed line 210. After the co-evaporation is completed, the base support 500 may be outputted from the co-evaporation device 300 to the substrate 400 lower line device, and then getting the substrate 400 out and circulation of the base support 500 may be implemented by way of the base support transfer line 100.

As shown in FIG. 1, the substrate feed line 210 may be provided with a plurality of input lines 212, and each of the input lines 212 is connected to an input end of the co-evaporation device 300. The substrate blanking line 220 is provided with a plurality of output lines 222, and each of the output lines 222 is connected to an output end of the co-evaporation device 300. Thus, simultaneous co-evaporation of a plurality of substrates 400 may be implemented, and the production efficiency may be increased.

Further, the solar cell co-evaporation production line further includes a substrate upper line apparatus 600 and a substrate lower line apparatus 700. Both the substrate upper line apparatus 600 and the substrate lower line apparatus 700 are connected to the base support transfer line 100. The substrate upper line apparatus 600 is used for conveying the substrate 400 onto the base support 500, and the substrate lower line apparatus 700 is used for taking away the substrate 400 from the base support 500. The substrate upper line apparatus 600 is connected to the previous process production line, such that the substrate 400 processed by the previous process may be conveyed to the solar cell co-evaporation production line via the substrate upper line apparatus 600. Correspondingly, the substrate lower line apparatus 700 may be connected to the next process production line, such that the substrate 400 may be conveyed to the next process production line via the substrate lower line apparatus 700 after the co-evaporation is completed to carry out the subsequent processing.

Further, the solar cell co-evaporation production line further includes a base support upper line apparatus 800 and a base support lower line apparatus 900. The base support upper line apparatus 800 is connected to the base support upper line port and is used for conveying the base support 500 onto the base support transfer line 100. The base support lower line apparatus 900 is connected to the base support lower line port and is used for recycling the base support 500 from the base support transfer line 100. Staff may manually place the base support 500 onto the base support upper line apparatus 800, or manually take the base support 500 down from the base support lower line apparatus 900, which facilitates operation for the staff, and also allows the staff to keep away from the base support transfer line 100 in operation, thereby ensuring personal safety of the staff.

Further, as shown in FIG. 1, to implement automatic circulation of the base support 500, the base support upper line apparatus 800 may be connected to the base support lower line apparatus 900, such that the base support 500 circulating onto the base support lower line apparatus 900 may be automatically transferred to the base support upper line apparatus 800 to prepare for a next round of circulation. Therefore, the staff may need not to take the base support 500 down from the base support lower line apparatus 900 and then place the base support 500 onto the base support upper line apparatus 800, and thus circulation steps of the base support 500 are simplified and the circulation efficiency is increased.

It is to be noted that in the process prior to the co-evaporation process, a side of the substrate 400 required for co-evaporation is arranged upward, whereas in the co-evaporation process, the side of the substrate 400 required for co-evaporation is arranged downward. However, in the prior art, typically the substrate 400 subject to the previous process is manually reversed, which causes a lower production efficiency and a larger labor intensity of the staff. In this embodiment, to solve the above problems, as shown in FIG. 2, both the substrate upper line apparatus 600 and the substrate lower line apparatus 700 are provided with a driving mechanism, a reversing mechanism, and a clamping mechanism 30. An output end of the driving mechanism is connected to one end of the reversing mechanism to drive the reversing mechanism to rotate, and the reversing mechanism is connected to the clamping mechanism 30. When the base support 500 is transferred to the substrate upper line apparatus 600, the driving mechanism may drive the reversing mechanism to rotate to a direction where the substrate 400 is. The clamping mechanism 30 clamps up the substrate 400 subject to the previous process and then the reversing mechanism clamping the substrate 400 is driven to rotate by 180°toward an opposite direction, such that the substrate 400 is reversed by 180°and is placed on the base support 500. Next, the clamping mechanism 30 releases the substrate 400, and the substrate 400 is circulated with the base support 500. In this way, automatic reversing and circulation of the substrate 400 are implemented, the production efficiency is increased, and the labor force is saved.

The clamping mechanism 30 may be a mechanical clamp. Clamping up or releasing the substrate 400 is implemented by controlling the clamp to open or close. However, it is not easy to control the clamp force of the mechanical clamp, and thus the substrate 400 may be damaged. Pickup of the substrate 400 is implemented by a vacuum chuck using the principle of controlling air pressure, and thus it is not easy to damage the substrate 400 because it is easy to control the air pressure. Therefore, in this embodiment, preferably, the clamping mechanism 30 is a vacuum chuck, the reversing mechanism is provided with a vacuum pump, and the vacuum pump is connected to the vacuum chuck. Specifically, the driving mechanism may be a motor. The reversing mechanism may include a rotating arm 10 and a rotating shaft 20. One end of the rotating arm 10 is vertically connected to the rotating shaft 20. The vacuum chuck is arranged on the rotating arm 10. One end of the rotating shaft 20 is connected to the driving motor, which may drive the rotating shaft 20 to rotate, and then drive the rotating arm 10 to reverse, as shown in FIG. 2.

To precisely control the transferring location of the base support 500 on the substrate upper line apparatus 600 and the substrate lower line apparatus 700, the solar cell co-evaporation production line may further include a position detecting apparatus. The position detecting apparatus is respectively arranged on the substrate upper line apparatus 600 and the substrate lower line apparatus 700. When the base support 500 is transferred to the substrate upper line apparatus 600, the position detecting apparatus may send a location signal of the base support 500 to the master control room, such that the base support 500 stays at the substrate upper line apparatus 600 for preset time, and in the meantime the driving mechanism is triggered to start, controlling the reversing mechanism to place the substrate 400 onto the base support 500. In this way, precise control in reversing, transferring and circulating the substrate 400 is implemented.

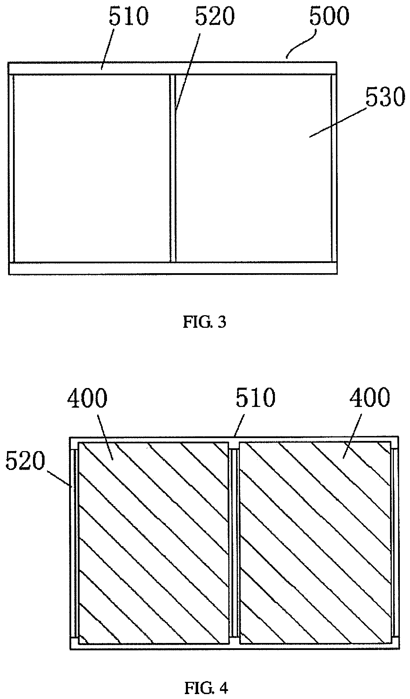

Referring to FIG. 1, FIG. 3 and FIG. 4, the base support 500 may include a longitudinal beam 510 and a cross beam 520 perpendicular to each other. At least two co-evaporation areas 530 for placing the substrate 400 are formed between the longitudinal beam 510 and the cross beam 520. The co-evaporation area 530 is of a hollow-carved design. The substrate 400 may be arranged on the longitudinal beams 510 which are symmetrically arranged, such that co-evaporation may be performed on the lower surface of the substrate 400 through the co-evaporation area 530. Designing at least two co-evaporation areas 530 may improve the carry capacity of the base support 500, and implement a circulation of a plurality of substrates 400. In this embodiment, the number of the co-evaporation areas 530 may be two. Moreover, there may be provided two substrate upper line apparatuses 600, and a certain interval is provided between the two substrate upper line apparatuses 600 in the circulation direction of the base support transfer line 100. When the base support 500 is transferred with the base support transfer line 100, two substrates 400 may be respectively transferred onto the same base support 500 by the two substrate upper line apparatuses 600. Correspondingly, there may be provided two substrate lower line apparatuses 700, by which the two substrates 400 may be respectively taken down from the same base support 500.

The solar cell co-evaporation production line provided by the present disclosure implements automatic transferring and processing of a copper-indium-gallium-selenium (CIGS) thin-film cell in a co-evaporation process by arranging the base support transfer line and the substrate transfer line, also implements an automatic circulation of the base support, saves manpower, increases production efficiency, and saves production costs.

The above embodiments as shown in the drawings illustrate the structure, the features and the effects of the solar power generation apparatus in detail, and the above embodiments are merely preferred embodiments of the present disclosure. However, the present disclosure does not limit the scope of implementation according to what is shown in the figures. Any modifications made in accordance with the conception of the present disclosure or equivalent embodiments revised as equivalent changes shall fall within the scope of protection of the present disclosure as long as they are within the spirit of the specification and the spirit covered by the drawings.

## Claims

1. A solar cell co-evaporation production line, comprising:
a base support transfer line, provided with a base support upper line port and a base support lower line port;
a substrate transfer line, connected to a co-evaporation device and provided with a feed port and a discharge port, both the feed port and the discharge port being connected to the base support transfer line; and
a master control room, used for controlling the base support transfer line and the substrate transfer line to act.

2. The solar cell co-evaporation production line according to claim 1, further comprising a substrate upper line apparatus and a substrate lower line apparatus connected to the base support transfer line, wherein the substrate upper line apparatus is used for conveying a substrate onto the base support, and the substrate lower line apparatus is used for taking away the substrate from the base support.

3. The solar cell co-evaporation production line according to claim 1, further comprising a base support upper line apparatus and a base support lower line apparatus, wherein the base support upper line apparatus is connected to the base support upper line port and is used for conveying the base support onto the base support transfer line, and the base support lower line apparatus is connected to the base support lower line port and is used for recycling the base support from the base support transfer line.

4. The solar cell co-evaporation production line according to claim 3, wherein the base support upper line apparatus is connected to the base support lower line apparatus.

5. The solar cell co-evaporation production line according to claim 1, wherein both the substrate upper line apparatus and the substrate lower line apparatus are provided with a driving mechanism, a reversing mechanism, and a clamping mechanism, an output end of the driving mechanism is connected to one end of the reversing mechanism to drive the reversing mechanism to rotate, and the reversing mechanism is connected to the clamping mechanism.

6. The solar cell co-evaporation production line according to claim 5, wherein the clamping mechanism is a vacuum chuck, the reversing mechanism is provided with a vacuum pump, and the vacuum pump is connected to the vacuum chuck.

7. The solar cell co-evaporation production line according to claim 5, further comprising a position detecting apparatus, wherein the position detecting apparatus is respectively arranged on the substrate upper line apparatus and the substrate lower line apparatus.

8. The solar cell co-evaporation production line according to claim 5, wherein the base support comprises a longitudinal beam and a cross beam perpendicular to each other, and at least two co-evaporation areas for placing the substrate are formed between the longitudinal beam and the cross beam.

9. The solar cell co-evaporation production line according to claim 1, wherein the substrate transfer line comprises a substrate feed line and a substrate blanking line, the substrate feed line is connected to an input end of the co-evaporation device, the substrate blanking line is connected to an output end of the co-evaporation device; and the feed port is arranged on the substrate feed line, and the discharge port is arranged on the substrate blanking line.

10. The solar cell co-evaporation production line according to claim 9, wherein the substrate feed line is provided with a plurality of input lines, each of the input lines is connected to an input end of the co-evaporation device, the substrate blanking line is provided with a plurality of output lines, and each of the output lines is connected to an output end of the co-evaporation device.
